# EUROPEAN PATENT SPECIFICATION

(11) **EP 2 869 669 B1**
(45) Date of publication and mention of the grant of the patent: **28.03.2018**
(21) Application number: 12882960.3
(22) Date of filing: 14.12.2012
(51) Int. Cl.: H05B 37/02, H05B 33/08

(54) **METHOD TO DETERMINE THE LIFESPAN OF AN LED ILLUMINATION DEVICE**
VERFAHREN ZUR BESTIMMUNG DER LEBENSDAUER EINER LED-BELEUCHTUNGSVORRICHTUNG
PROCÉDÉ DE DÉTERMINATION DE DURÉE DE VIE EN SERVICE D'UN DISPOSITIF D'ÉCLAIRAGE À DEL

(30) Priority: 16.08.2012 CN 201210292622
(43) Date of publication of application: 06.05.2015
(73) Proprietor: Zhejiang Shenghui Lighting Co., Ltd, Jiaxing, Zhejiang 314501 (CN)
(72) Inventor: SHEN, Jinxiang, Jiaxing Zhejiang 314501 (CN); CHEN, Fang, Jiaxing Zhejiang 314501 (CN); WAN, Yehua, Jiaxing Zhejiang 314501 (CN)
(74) Representative: Jöstingmeier, Martin
(86) International application number: PCT/CN2012/086612
(87) International publication number: WO 2014/026455

(56) References cited:
- CN-A- 102 413 609
- CN-A- 102 413 609
- CN-A- 102 821 523
- CN-U- 201 509 347
- CN-U- 201 509 347
- CN-Y- 2 386 449
- CN-Y- 2 386 449
- JP-A- 2004 247 273
- JP-A- 2012 126 514
- JP-A- 2012 126 514
- KR-A- 20120 045 429
- US-A1- 2011 254 554

## Description

### TECHNICAL FIELD

The present disclosure relates to the field of light emitting diode (LED) technologies and, more particularly, relates to a method for determining the lifespan of the LED lighting device.

### BACKGROUND TECHNOLOGY

With the rapid development of new energy-efficient lighting technologies in recent years, especially the LED technology, lighting products have become more efficient and durable. Compared with traditional incandescent lamps, the light conversion efficiency of an LED lamp may be 5 to 10 times higher, and the lifespan of an LED lamp may be 30 to 50 times longer. As a result, energy saving improvements have been well received by commercial and individual users. Moreover, innovative financing methods used in energy-saving projects, especially the Energy Management Contract (EMC) mode, attract more and more attention. New energy-saving lighting products such as LEDs have very long lifespans in theory. (The lifespan of a lighting product may be defined as the duration during which its illuminous flux is maintained at, for example, above 70% of the original illuminous flux.) Because there is no practical method to speed up the aging process to measure the lifespan of an LED lighting device, one conventional method is to measure a device's illuminous flux maintenance factor after 6,000 hours' or longer time's aging to estimate its lifespan. Due to the rapid development of new energy-efficient LED technologies, one technology may become obsolete even before or just when its product's lifespan can be fully tested. For LED manufacturers, this may cause double waste of money and time. For LED device users, unless a device fails in a relatively short time, it may be difficult to accurately obtain the real lifespan of a lighting device. It may even be harder to compare the lifespan measurements to the claimed lifespan of a lighting product, which may harm the users' legitimate interests. For example, one product may claim that it has a lifespan of 25,000 hours. If it failed after 20,000 hours of usage, it would be difficult for the user to show evidence and protect his/her rights. As a result, estimating and verifying the lifespan of the new energy-efficient LED devices may be a great challenge to device manufacturers and users.

US 2011/254554 A1 suggests a method for estimating the life span of a LED light. To this end the conditions like temperature, humidity and the like, under which the LED light operates are measured as well as illuminance data of the LED light. A controller extrapolates the illuminance data as a function of the conditions and provides an estimate for the remaining time the LED light operates in its specification.

CN102413609 suggests a LED-lamp with a cooling fan. To extend make best use of the cooling fan's life the cooling fan is switched on and off in response to temperature variations of a power converter for powering the LEDs.

KR 10-2012-0045429 relates to a method for providing service time information of a luminous element by generating residual service time information of the luminous element module by using measured luminous intensity information. JP2004/247273 provides a light control system enabling to measure accumulated lighting time even if the light is connected to a dimmer

CN 201509347 U relates to an auxiliary light source with a timing function. The light source comprises a controller, an optical sensor and an LED, wherein the optical sensor is arranged nearby the LED and used for sensing the light emission of the LED and for transmitting a corresponding sensing signal to the controller. The controller times the light emission of the LED based on the signals of the optical sensor.

CN 2386449Y suggests a method for estimating the service life of technical products, in particular of defense products. The basic idea is to collect current and voltage signals form a power measurement circuit and to use these data to determine the service life.

JP002012126514A relates to a passenger conveyor with a LED light and power supply. The estimate the lifespan of the LED light or the power supply, a control section determines calculates an integrated lighting time of the LED or the power supply and calculates a corrected integrated lighting time by multiplying the integrated lighting time by a correction factor. The correction factor increases as the detected temperature of a temperature sensor increases. A signal is provided on a display when the corrected integrated lighting time reaches the lifespan of the LED or power supply.

### SUMMARY OF THE DISCLOSURE

### Solution to the problem

### Technical solution

The present disclosure overcomes the disadvantages in the above-mentioned prior art, and provides an LED lighting device that is capably of timely obtaining its usage time and showing its own lifespan, and a method for determining the lifespan.

The technical solution of the present invention is implemented as follows:

An LED lighting device, the LED lighting device may include a controller configured to keep time; a low voltage DC power source configured to supply power; and a display terminal connected to the controller.

Optionally, the low voltage DC power source is connected to the controller.

The low voltage DC power source supplies power to the controller and the display terminal.

Optionally, the controller is a microcontroller or a digital integrated circuit controller.

Optionally, the controller is connected directly to the display terminal.

Optionally, the controller being connected directly to the display terminal means that: the display terminal is attached to the LED lighting device and the controller sends the time keeping data to be displayed on the display terminal. The display terminal may be an LCD display.

Further, to accurately measure the life span of the LED lighting device, optionally, a light intensity sensor is placed at a luminous zone of the LED lighting device; the light sensor is connected to the controller; and the controller captures the illuminance data and converts the data into a luminous flux and a luminous flux maintenance factor, or sends the illuminance data to the display terminal.

To facilitate easy assembly, optionally, the light intensity sensor is fixed on a substrate/PCB board that is also used to hold LED light sources.

To better measure illuminance, optionally, the light intensity sensor is placed at the center of the substrate/PCB board.

To prevent problems caused by external lights, optionally, a cup is placed outside the light intensity sensor.

To ensure the light sensor only receives internal light and take accurate measurements, optionally, a shading slide is placed above the light intensity sensor and on top of a LED lampshade.

Optionally, the controller includes an internal timing circuit or a timing program to keep time. Thus, the controller has time keeping capabilities.

A method for determining the lifespan of an LED lighting device, including placing a controller having time-keeping capabilities and a low voltage DC power source for supplying power inside the LED lighting device; when the power source is connected to power, the LED lighting device starts illuminating light, the controller starts to keep time data simultaneously, the time data is obtained by the controller and stores in the controller or displays on the display terminal, the time-keeping controller has power failure protection capabilities to keep the time data, and can continue timing when the power is back on again; until when the LED lighting device shows insufficient luminance, the displayed time is the lifespan of the LED lighting device.

Optionally, placing a sensor in the luminous zone of the LED lighting device; obtaining an initial record as the initial illuminance data record related to the LED lighting device when the LED lighting device is first turned on and has been on for 20-60 minutes' of pre-heating, the initial illuminance data record being transmitted to the controller simultaneously; recording subsequent illuminance data records related to the LED lighting device when the LED lighting device has been on for each additional 20-30 minutes; using a built-in program, the controller comparing the real-time illuminance data with the initial illuminance data, and converting the illuminance data records into a luminous flux or a luminous flux maintenance factor; sending the luminous flux or the luminous flux maintenance factor to the display terminal to be displayed; and determining the lifespan of the LED lighting device to be the recorded operation time when the measured luminous flux maintenance factor drops below a threshold luminous maintenance factor predetermined for critical lifespan.

Further, to record accurate initial illuminance value, optionally, the method includes obtaining an initial record when the LED lighting device is first turned on and has been on for 20-60 minutes' of pre-heating, recording the subsequent illuminance data records 3-5 times for each additional 20-30 minutes; comparing the measured subsequent illuminance data records to the initial record to determine a variance; setting the initial illuminance value to be equal to any one of the measured records or their average if the variance is less than 10%; or discarding the records if the variance is greater than 10%. In this way, being obtained after the LED lighting device is operating steadily, the initial illuminance data can be more accurate.

To avoid data loss caused by certain malfunction of the LED lighting device, optionally, when the LED lighting device encounters various malfunctions and is not working normally, an external low voltage DC power source may be provided to the controller, and the controller may provide the recorded or displayed illuminance data records related to the LED lighting device. One or more power supply and data transmission ports may be reserved on the controller, such as a USB port. When the LED lighting device is not working normally, the external low voltage DC power supply may be connected to the controller through the port so that the controller may continue working to record related data or transmit related data for reading.

### Advantageous effects

The design concept and advantageous effects of the present disclosure that adopts the aforementioned technical solutions are as follows:

The present disclosure adds into an LED lighting device with a controller that has time keep capabilities. The controller keeps data of the operation time of the LED lighting device in real time and sends the data to a display terminal to be displayed. A light intensity sensor is meanwhile placed in the luminous zone of the LED device to capture illuminance data and calculates the luminous flux maintenance factor in real time. When the measured luminous flux maintenance factor drops below a threshold luminous maintenance factor predetermined for critical lifespan, the recorded operation time of the LED lighting device is the lifespan of the LED lighting device.

The present disclosure can record the working time of the LED lighting device and the corresponding luminous flux maintenance factor, can accurately determine the real lifespan characteristics of efficient and durable lighting products such as LED lighting devices, and can provide accurate information to various business applications for evaluating the lifespan and operating models of efficient and durable lighting products such as LED lighting devices.

### BRIEF DESCRIPTION OF THE DRAWINGS

### Description of the drawings

FIG. 1 depicts an exemplary LED lighting device configuration consistent with disclosed embodiments;
FIG. 2 depicts a schematic diagram of an exemplary micro controller unit (MCU) controller with another power supply configuration consistent with disclosed embodiments; and
FIG. 3 is a schematic illustrating various modules in the LED lighting device consistent with disclosed embodiments.

### EMBODIMENTS OF THE DISCLOSURE

### Embodiments of the present invention

Detailed embodiments consistent with the present disclosure are described below.

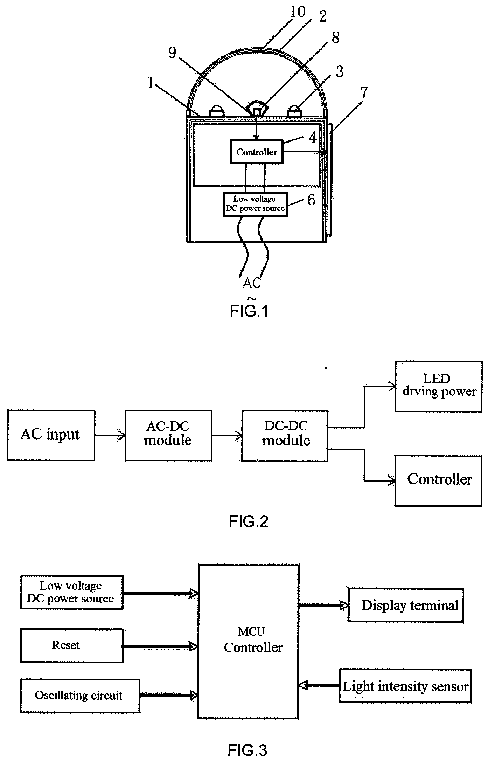

Embodiment: an LED lighting device, as shown in FIG. 1, a substrate/PCB board land a lampshade 2 are configured on an upper part of the LED lighting device, multiple LED light sources 3 are fixed on the substrate/PCB board 1, a controller 4 and a low voltage DC power supply 6 are placed inside the LED lighting device. The controller 4 may be an MCU controller. As shown in FIGs. 1 and 3, the low voltage DC power supply 6 may be connected to the controller 4. The controller 4 may be connected to a display terminal 7. The display terminal 7 may be placed on the lateral side of the LED lighting device, and may be an LCD display.

A light intensity sensor 8 may be placed at the luminous zone inside the LED lighting device. The light intensity sensor 8 may be connected to the controller 4. The light intensity sensor 8 may measure the illuminance of the LED lighting device. The controller 4 may read and convert the illuminance data from the sensor into the luminous flux maintenance factor, and may send the data to the display terminal 7. The light intensity sensor 8 may be placed at the center of the substrate/PCB board 1. The cup 9 may be set outside the light intensity sensor 8. A shading slide 10 may be placed above the light intensity sensor 8.

The controller 4 may need a low voltage DC power supply. Often, the LED power supply can also output low voltage DC power. Thus, the low voltage DC power source 6 may supply power to the controller 4 directly. If other types of power source are used, as shown in FIG. 2, an AC-DC module and a DC-DC module may be needed for voltage conversions.

When the power is on, the LED light sources may start emitting light. At the same time, the MCU controller may start keeping time. The lifespan time data may be displayed on the display terminal. The controller may have a power failure data protection function for time keeping, which may keep track of the time data during a power-off period. When the power is turned on again, the controller may resume time keeping. The time keeping functions may keep running until the LED light sources cannot emit sufficient light. The final recorded and displayed duration may be the lifespan of the LED lighting device.

Further, the light intensity sensor may take a first illuminance measurement 30 minutes after the LED lighting device is powered on. Then, the sensor may take another three consequent illuminance measurements every 30 minutes. The light intensity measurements may then be compared with the first illuminance measurement. If the variance is within 10%, the controller may set the average of these measurements as the initial illuminance value. The sensor may also send this initial illuminance value to the MCU controller. Thereafter, the light intensity sensor may measure light intensity every 30 minutes. The light intensity sensor may be configured to not take the light intensity readings during the power-off processes. The controller may, according to a built-in program, compare an illuminance measurement data retrieved in real time with the initial illuminance value, convert the illuminance measurement data into the luminous flux and the luminous flux maintenance factor, and send the luminous flux and the luminous flux maintenance factor to the display terminal. When the measured luminous flux maintenance factor is lower than a pre-defined value of luminous maintenance factor for critical lifespan, the recorded working time by the LED lighting device may be its lifespan. The pre-defined value of luminous maintenance factor for critical lifespan may be defined based on specific applications. For example, the luminous flux maintenance factor threshold may be generally set at 70%.

## Claims

1. A method for determining the lifespan of an LED lighting device, comprising:
- placing a controller (4) having time-keeping capabilities and a low voltage DC power source (6) inside the LED lighting device, wherein the low voltage DC power source (6) supplies power to the controller (4);
- placing a light intensity sensor (8) in a luminous zone of the LED lighting device, wherein the light sensor (8) is connected to the controller;
- by the controller (4), capturing illuminance data and converting the illuminance data into a luminous flux maintenance factor or sending the illuminance data to a display terminal (7);
- when the power source (6) is connected to power:
a. the LED lighting device starts illuminating light,
b. the controller (4) starts to keep time data as recorded time simultaneously, and
c. time data is obtained by the controller (4) and stored in the controller (4) or displayed on the display terminal (7),
**characterized in that** the method comprises:
- obtaining an initial record as the initial illuminance data record related to the LED lighting device when the LED lighting device is first turned on and has been on for 20-60 minutes of pre-heating;
- transmitting the initial illuminance data record from the sensor to the controller (4) simultaneously;
- recording subsequent illuminance data records related to the LED lighting device when the LED lighting device has been on for each additional 20-30 minutes;
- using a built-in program, the controller (4) comparing the recorded subsequent illuminance data with the initial illuminance data, and converting the illuminance data records into a luminous flux and a luminous flux maintenance factor;
- sending the luminous flux or the luminous flux maintenance factor to the display terminal (7) to be displayed; and
- determining the lifespan of the LED lighting device to be the recorded operation time, when the luminous flux maintenance factor drops below a threshold value when the illuminance data shows insufficient luminance.

2. The method of claim 1, **characterized in that** it further comprises:
- recording the subsequent illuminance data records 3-5 times for each additional 20-30 minutes;
- comparing the measured illuminance data records to the initial illuminance data record to determine a variance; and
- setting the initial illuminance data record to be equal to an average of the measured illuminance data records if the variance is less than 10%.

3. The method of claim 1, **characterized in that** when the LED lighting device is not working normally,
- the controller is connected to an external low voltage DC power source (6), and
- the controller may continue working to record related data or transmit related data for reading.

## Patentansprüche

1. Verfahren zum Bestimmen der Lebensdauer einer LED-Beleuchtungsvorrichtung, umfassend:
- Anordnen einer Steuerung (4) mit Zeitmessungsfähigkeit und einer Niederspannungs-Gleichstromquelle (6) innerhalb der LED-Beleuchtungsvorrichtung, wobei die Niederspannungs-Gleichstromquelle (6) die Steuerung (4) mit Strom versorgt;
- Anordnen eines Lichtintensitätssensors (8) in einer Leuchtzone der LED-Beleuchtungsvorrichtung, wobei der Lichtintensitätssensor (8) mit der Steuerung verbunden ist;
- Erfassen von Lichtintensitätsdaten durch die Steuerung (4) und Konvertieren der Lichtintensitätsdaten in einen Lichtstromerhaltungsfaktor oder Senden der Lichtintensitätsdaten an ein Anzeigeterminal (7);
- wenn die Stromquelle (6) an den Strom verbunden ist:
a. die LED-Beleuchtungsvorrichtung beginnt Licht auszustrahlen;
b. die Steuerung (4) simultan beginnt, Zeitdaten als aufgezeichnete Zeit zu messen; und
c. Zeitdaten durch die Steuerung (4) erfasst werden und in der Steuerung (4)
gespeichert werden oder auf dem Anzeigeterminal (7) angezeigt werden; **dadurch gekennzeichnet, dass** das Verfahren umfasst:
- Erfassen einer anfänglichen Aufzeichnung als anfänglicher Lichtintensitätsdatensatz bezüglich der LED-Beleuchtungsvorrichtung, wenn die LED-Beleuchtungsvorrichtung erstmals eingeschaltet wird und für 20-60 Minuten des Vorwärmens eingeschaltet war;
- Simultanes Übermitteln des anfänglichen Lichtintensitätsdatensatzes vom Sensor zur Steuerung (4);
- Aufzeichnen nachfolgender Lichtintensitätsdatensätze bezüglich der LED-Beleuchtungsvorrichtung, wenn die LED-Beleuchtungsvorrichtung für jeweils weitere 20-30 Minuten eingeschaltet war;
- unter Verwendung eines integrierten Programms vergleicht die Steuerung (4) die aufgezeichneten nachfolgenden Lichtintensitätsdatensätze mit den anfänglichen Lichtintensitätsdatensätzen und konvertiert die Lichtintensitätsdatensätze in einen Lichtstrom und einen Lichtstromerhaltungsfaktor;
- Senden des Lichtstroms oder des Lichtstromerhaltungsfaktors an das Anzeigeterminal (7), zum Anzeigen; und
- Bestimmen der Lebensdauer der LED-Beleuchtungsvorrichtung als die aufgezeichnete Betriebsdauer, wenn der Lichtstromerhaltungsfaktor unter einen Schwellenwert fällt, wenn die Lichtintensitätsdatensätze unzureichende Beleuchtung zeigen;

2. Verfahren nach Anspruch 1,
**dadurch gekennzeichnet, dass** es weiterhin umfasst:
- Aufzeichnen der nachfolgenden Lichtintensitätsdatensätze 3-5mal für jede zusätzlichen 20-30 Minuten;
- Vergleichen der gemessenen Lichtintensitätsdatensätze mit dem anfänglichen Lichtintensitätsdatensatz, um eine Varianz zu bestimmen; und
- Setzen des anfänglichen Lichtintensitätsdatensatzes auf den Durchschnitt der gemessenen Lichtintensitätsdatensätze, wenn die Varianz kleiner als 10% ist.

3. Verfahren nach Anspruch 1,
**dadurch gekennzeichnet, dass**, wenn die LED-Beleuchtungsvorrichtung nicht normal arbeitet:
- die Steuerung mit einer externen Niederspannungs-Gleichstromquelle (6) verbunden wird, und
- die Steuerung den Betrieb fortsetzen kann, um dazugehörige Daten aufzuzeichnen oder dazugehörige Daten zum Lesen zu übermitteln.

## Revendications

1. Procédé pour déterminer la durée de vie d'un dispositif d'éclairage à DEL, comprenant :
- la mise en place d'un contrôleur (4) ayant des propriétés de garde-temps et d'une source de courant continu à basse tension (6) à l'intérieur du dispositif d'éclairage à DEL, la source de courant continu à basse tension (6) fournissant l'alimentation du contrôleur (4) ;
- la mise en place d'un capteur d'intensité lumineuse (8) dans une zone lumineuse du dispositif d'éclairage à DEL, le capteur de lumière (8) étant connecté au contrôleur ;
- l'acquisition par le contrôleur (4) de données d'éclairement et la conversion des données d'éclairement en un facteur de maintien du flux lumineux ou l'envoi des données d'éclairement à un terminal d'affichage (7) ;
- quand la source de courant (6) est raccordée à l'alimentation :
a. le dispositif d'éclairage à DEL commence à émettre de la lumière ;
b. le contrôleur (4) commence à conserver en même temps des données de temps sous la forme du temps enregistré, et
c. des données de temps sont obtenues par le contrôleur (4) et stockées dans le
contrôleur (4) ou affichées sur le terminal d'affichage (7), **caractérisé en ce qu'**il comprend :
- l'obtention d'un enregistrement initial sous la forme d'un enregistrement initial de données d'éclairement relié au dispositif d'éclairage à DEL quand le dispositif d'éclairage à DEL est activé pour la première fois et fonctionne depuis 20 à 60 minutes de préchauffage ;
- la transmission simultanée de l'enregistrement initial de données d'éclairement du capteur au contrôleur (4) ;
- l'enregistrement d'enregistrements de données d'éclairement subséquent associés au dispositif d'éclairage à DEL quand celui-ci fonctionne depuis 20 à 30 autres minutes ;
- à l'aide d'un programme intégré, la comparaison par le contrôleur (4) des données d'éclairement subséquent enregistrées avec les données d'éclairement initiales et la conversion des enregistrements de données d'éclairement en un flux lumineux et un facteur de maintien du flux lumineux ;
- l'envoi du flux lumineux ou du facteur de maintien du flux lumineux au terminal d'affichage (7) pour affichage ; et
- la détermination de la durée de vie du dispositif d'éclairage à DEL sous la forme du temps de fonctionnement enregistré auquel le facteur de maintien du flux lumineux baisse en dessous d'une valeur de seuil quand les données d'éclairement montrent une luminance insuffisante.

2. Procédé selon la revendication 1, **caractérisé en ce qu'**il comprend en outre :
- l'enregistrement des enregistrements de données d'éclairement suivants 3 à 5 fois par 20 à 30 autres minutes ;
- la comparaison des enregistrements de données d'éclairement mesurés à l'enregistrement initial de données d'éclairement pour déterminer une variance ; et
- le réglage de l'enregistrement initial de données d'éclairement à une valeur égale à la moyenne des enregistrements de données d'éclairement mesurés si la variance est inférieure à 10 %.

3. Procédé selon la revendication 1, **caractérisé en ce que** lorsque le dispositif d'éclairage à DEL ne fonctionne pas normalement,
- le contrôleur est connecté à une source de courant continu à basse tension externe (6), et
- le contrôleur peut continuer à fonctionner pour enregistrer les données correspondantes ou transmettre les données correspondantes à la lecture.
